# EUROPÄISCHE PATENTSCHRIFT

(11) **EP 1 741 170 B1**
(45) Veröffentlichungstag und Bekanntmachung des Hinweises auf die Patenterteilung: **04.03.2009**
(21) Anmeldenummer: 05744010.9
(22) Anmeldetag: 11.04.2005
(51) Int. Cl.: H01S 5/183, H01S 5/04

(54) **OPTISCH GEPUMPTE HALBLEITERVORRICHTUNG**
OPTICALLY PUMPED SEMICONDUCTOR DEVICE
DISPOSITIF A SEMI-CONDUCTEURS A POMPAGE OPTIQUE

(30) Priorität: 30.04.2004 DE 102004021265; 31.08.2004 DE 102004042146
(43) Veröffentlichungstag der Anmeldung: 10.01.2007
(73) Patentinhaber: OSRAM Opto Semiconductors GmbH, 93055 Regensburg (DE)
(72) Erfinder: KARNUTSCH, Christian, 76139 Karlsruhe (DE); LINDER, Norbert, 93138 Lappersdorf (DE); SCHMID, Wolfgang, 93180 Deuerling / Hillohe (DE)
(74) Vertreter: Epping - Hermann - Fischer
(86) Internationale Anmeldenummer: PCT/DE2005/000649
(87) Internationale Veröffentlichungsnummer: WO 2005/107027

(56) Entgegenhaltungen:
- WO-A-02/067393
- US-A1- 2004 022 286
- US-A1- 2004 042 523
- PATENT ABSTRACTS OF JAPAN Bd. 1996, Nr. 01, 31. Januar 1996 (1996-01-31) & JP 07 249824 A (HITACHI LTD), 26. September 1995 (1995-09-26)
- GERHOLD M D ET AL: "NOVEL DESIGN OF A HYBRID-CAVITY SURFACE-EMITTING LASER" IEEE JOURNAL OF QUANTUM ELECTRONICS, IEEE SERVICE CENTER, PISCATAWAY, NJ, US, Bd. 34, Nr. 3, März 1998 (1998-03), Seiten 506-510, XP000742645 ISSN: 0018-9197 in der Anmeldung erwähnt

## Beschreibung

Die vorliegende Erfindung bezieht sich auf eine optisch gepumpte Halbleitervorrichtung nach dem Oberbegriff des Patentanspruchs 1.

Eine gattungsgemäße Halbleitervorrichtung ist beispielsweise aus der Druckschrift WO 01/93396 bekannt. Hierin ist ein optisch gepumpter Vertikalemitter beschrieben, der zusammen mit einer Pumpstrahlungsquelle, beispielsweise einem kantenemittierenden Halbleiterlaser monolithisch integriert ausgeführt ist. US 2004/0042523 offenbart ebenfalls eine derartige Vorrichtung.

Um eine hohe Pumpeffizienz zu erreichen, ist es erforderlich, dass die Pumpwellenlänge kleiner ist als die Emissionswellenlänge des Vertikalemitters. Die verschiedenen Wellenlängen werden beispielsweise durch verschiedene Strukturen und Materialzusammensetzungen von Pumpstrahlungsquelle beziehungsweise Vertikalemitter erreicht.

Eine solche Halbleitervorrichtung kann beispielsweise hergestellt werden, indem zunächst auf einem Substrat ganzflächig die Schichten für den Vertikalemitter aufgewachsen und nachfolgend in lateral außenliegenden Bereichen diese Schichten partiell wieder abgeätzt werden. In den abgeätzten Bereichen werden in einem zweiten Epitaxieschritt die Schichten für die Pumpstrahlungsquelle, beispielsweise einen kantenemittierenden Halbleiterlaser aufgewachsen.

Allerdings erfordert eine Herstellung mit zwei getrennten Epitaxieschritten einen vergleichsweise hohen Aufwand. Weiterhin ist darauf zu achten, dass zwischen der Pumpstrahlungsquelle und dem Vertikalemitter ein guter optischer Übergang ausgebildet wird, um Absorptionsverluste an dieser Stelle gering zu halten.

Aus Gerhold et al., IEEE Journal of Quantum Electronics, Vol. 34, No. 3, 1998, Seite 506 bis 511, ist weiterhin eine optisch gepumpte Halbleitervorrichtung bekannt, die eine einzige durchgehende aktive Schicht mit einer Quantentopfstruktur aufweist. In den lateral außenliegenden Bereichen ist die Quantentopfstruktur der aktiven Schicht durchmischt, so dass in diesem Bereich im Vergleich zum Zentralbereich Strahlung einer kürzeren Wellenlänge erzeugt wird, die als Pumpstrahlung für den Zentralbereich dient.

Da nur eine einzige aktive Schicht ausgebildet wird, kann allerdings die Pumpwellenlänge nur in einem vergleichsweise kleinem Bereich variiert werden. Zudem besteht die Gefahr, dass durch die Durchmischung der Quantentopfstrukturen in den lateral außenliegenden Bereichen die optischen Eigenschaften des Halbleiterkörpers beeinträchtigt werden, was zu einer Verringerung der Pumpeffizienz führen kann.

Es ist Aufgabe der vorliegenden Erfindung, eine optisch gepumpte Halbleitervorrichtung der eingangs genannten Art zu schaffen, die mit einem technisch geringen Aufwand herstellbar ist. Insbesondere soll diese Vorrichtung in einem Epitaxieverfahren ohne Unterbrechung herstellbar sein.

Diese Aufgabe wird durch eine optisch gepumpte Halbleitervorrichtung mit den Merkmalen des Patentanspruchs 1 gelöst. Vorteilhafte Weiterbildungen der Erfindung sind Gegenstand der abhängigen Ansprüche.

Erfindungsgemäß ist eine Halbleitervorrichtung mit einem optisch gepumpten Vertikalemitter, der eine aktive Vertikalemitterschicht aufweist, und einer Pumpstrahlungsquelle, mittels der ein in lateraler Richtung propagierendes Pumpstrahlungsfeld erzeugt wird, das die Vertikalemitterschicht in einem Pumpbereich optisch pumpt, wobei die Wellenlänge des Pumpstrahlungsfeldes kleiner ist als die Wellenlänge des von dem Vertikalemitter generierten Strahlungsfeldes, vorgesehen. Die Pumpstrahlungsquelle weist eine aktive Pumpschicht auf, die der Vertikalemitterschicht in vertikaler Richtung nachgeordnet ist und die in vertikaler Richtung gesehen zumindest teilweise, mit der Vertikalemitterschicht überlappt, wobei die aktive Pumpschicht so angeordnet ist, dass das im Betrieb erzeugte Pumpstrahlungsfeld eine höhere Leistung aufweist als ein parasitäres von der Vertikalemitterschicht erzeugtes, lateral propagierendes Strahlungsfeld, oder dass die Erzeugung eines parasitären, lateral propagierenden Strahlungsfeldes durch die Vertikalemitterschicht unterdrückt wird.

Vorzugsweise ist die Pumpstrahlungsquelle als Kantenemitter, insbesondere als kantenemittierender Laser ausgeführt. Weiter bevorzugt sind die Pumpstrahlungsquelle in Form eines Pumplasers und der Vertikalemitter in einen gemeinsamen Halbleiterkörper monolithisch integriert. Hierbei kann beispielsweise der Laserresonator des Pumplasers von Seitenflächen des Halbleiterkörpers gebildet werden, so dass der Pumpbereich des Vertikalemitters und weitergehend die aktive Vertikalemitterschicht innerhalb des Laserresonators angeordnet ist.

Die Erfindung geht von dem Gedanken aus, die aktive Vertikalemitterschicht und die aktive Pumpschicht in einem Epitaxieprozess nacheinander aufzuwachsen, ohne dass eine Unterbrechung des Epitaxieprozesses zur Entfernung bereits gewachsener Schichten erforderlich ist. Da die Pumpwellenlänge hinsichtlich eines effizienten Pumpprozesses kleiner ist die Emissionswellenlänge des Vertikalemitters, ist darauf zu achten, dass nicht auch in der Vertikalemitterschicht ein lateral propagierendes Strahlungsfeld erzeugt wird. Ein solches parasitäres Strahlungsfeld würde dieselbe Wellenlänge wie die vertikal emittierte Strahlung aufweisen und daher den Vertikalemitter nur unzureichend pumpen. Aus diesem Grund ist das Auftreten eines solchen Strahlungsfeldes unerwünscht. Bei der vorliegenden Erfindung ist die Pumpschicht so angeordnet, dass das im Betrieb erzeugte Pumpstrahlungsfeld zumindest eine höhere Leistung aufweist als ein parasitäres, lateral propagierendes Strahlungsfeld, das von der Vertikalemitterschicht erzeugt wird, wobei vorzugsweise die Erzeugung eines solchen parasitären Strahlungsfeldes weitestgehend oder sogar vollständig unterdrückt wird.

Die erfindungsgemäße Halbleitervorrichtung ist mit vergleichweise geringem technischen Aufwand herstellbar. Insbesondere ist es nicht erforderlich, nach dem Aufwachsen des Vertikalemitters den Epitaxieprozess zu unterbrechen, um Teile der Schichtenfolge wieder abzutragen und erneut in einem zweiten Epitaxieschritt die Pumpstrahlungsquelle aufzuwachsen. Weiterhin zeichnet sich die erfindungsgemäße Halbleitervorrichtung durch eine hohe Pumpeffizienz aufgrund der Trennung von aktiver Pumpschicht und aktiver Vertikalemitterschicht aus, wobei die Pumpwellenlänge und die Emissionswellenlänge je nach Gestaltung der jeweiligen aktiven Schicht in weiten Grenzen frei einstellbar sind.

Bei einer bevorzugten Ausgestaltung der Erfindung wird die Pumpstrahlungsquelle elektrisch durch Ladungsträgerinjektion, etwa die Injektion von Ladungsträgern eines ersten Ladungstyps und Ladungsträgern eines zweiten Ladungsträgertyps, zur Erzeugung der Pumpstrahlung angeregt. In der Regel weisen diese Ladungsträger je nach Typ verschiedene Nettoeinfangraten auf. Die Nettoeinfangrate entspricht hierbei der Wahrscheinlichkeit, dass ein Ladungsträger in der Pumpschicht rekombiniert. Die Nettoeinfangrate hängt unter anderem von der Mobilität der jeweiligen Ladungsträger ab.

Vorzugsweise weisen die Ladungsträger des ersten Ladungsträgertyps eine höhere Nettoeinfangrate als die Ladungsträger des zweiten Ladungsträgertyps auf und werden von einer Seite in die Halbleitervorrichtung injiziert, wobei die Pumpschicht einen geringeren Abstand von dieser Seite aufweist als die Vertikalemitterschicht. Mittels dieser Anordnung wird eine Gleichberechtigung der Pumpschicht und der Vertikalemitterschicht aufgehoben, so dass durch die Ladungsträgerinjektion in erster Linie in der Pumpschicht eine Strahlungserzeugung angeregt wird.

Bei einer weiteren Ausgestaltung der Erfindung ist zwischen der Vertikalemitterschicht und der Pumpschicht eine Barriere gebildet, die eine Selektivität hinsichtlich des Ladungsträgertyps aufweist. Hiermit wird ebenfalls die Gleichberechtigung zwischen der Pumpschicht und der Vertikalemitterschicht aufgehoben, so dass die injizierten Ladungsträger vermehrt in der Pumpschicht rekombinieren und somit die Erzeugung eines lateral propagierendes parasitäres Strahlungsfeld durch die Vertikalemitterschicht weitgehend vermieden wird.

Bei einer weiteren bevorzugten Ausführung der Erfindung ist die Halbleitervorrichtung teilweise mit dem ersten Leitfähigkeitstyp und teilweise mit dem zweiten Leitfähigkeitstyp dotiert, so dass beim Übergang der Dotierung vom ersten zum zweiten Leitfähigkeitstyp eine Raumladungszone gebildet ist. Hierbei ist die Pumpschicht innerhalb der Raumladungszone und die Vertikalemitterschicht außerhalb der Raumladungszone angeordnet mit der Folge, dass aufgrund der Ladungsträgerinjektion in erster Linie Strahlungserzeugung durch die Pumpschicht angeregt wird, und eine Anregung eines parasitären Strahlungsfeldes in der Vertikalemitterschicht weitgehend vermieden wird.

Die bisher genannten Merkmale der Erfindung bezogen sich hinsichtlich einer vorrangigen Strahlungserzeugung durch die Pumpschicht insbesondere auf deren Anordnung bezüglich einer elektrischen Anregung mittels Ladungsträgerinjektion.

Bei einer weiteren Ausgestaltung der Erfindung weist die Halbleitervorrichtung einen Wellenleiter auf, in dem sowohl die Vertikalemitterschicht als auch die Pumpschicht angeordnet ist, wobei die Anordnung der Pumpschicht so gewählt ist, dass das im Betrieb erzeugte Pumpstrahlungsfeld eine höhere Leistung aufweist als ein parasitäres lateral propagierendes Strahlungsfeld. Besonders bevorzugt wird die Erzeugung eines parasitären Strahlungsfeldes durch die Vertikalemitterschicht vollständig unterdrückt. Eine derartige Anordnung der aktiven Schichten innerhalb eines Wellenleiters kann alternativ oder im Kombination mit den bereits genannten Merkmalen der Erfindung vorgesehen sein.

Dem Wellenleiter ist eine Pumpmode zugeordnet, die hinsichtlich der Pumpschicht einen Füllfaktor Γₚ und hinsichtlich der Vertikalemitterschicht einen Füllfaktor Γᵥ aufweist, wobei die Pumpschicht vorzugsweise so angeordnet ist, dass der Füllfaktor Γₚ der Pumpschicht größer ist als der Füllfaktor Γᵥ der Vertikalemitterschicht. Dazu kann bei einer ersten Ausgestaltung der Erfindung die Pumpschicht näher an einem Intensitätsmaximum der Pumpmode angeordnet sein als die Vertikalemitterschicht, so dass der Füllfaktor Γₚ der Pumpschicht, das heißt der Überlapp der Pumpmode mit der Pumpschicht größer ist als der entsprechende Überlapp der Pumpmode mit der Vertikalemitterschicht. Dadurch wird eine stärkere Ankopplung der Pumpschicht an das Pumpstrahlungsfeld und damit eine bevorzugte Strahlungserzeugung mittels der Pumpschicht erreicht.

Ein höherer Füllfaktor der Pumpschicht gegenüber der Vertikalemitterschicht kann andererseits auch dadurch erzielt werden, dass als Pumpmode eine Mode mit einem Nulldurchgang, also einem Knoten gewählt ist, und die Vertikalemitterschicht näher an dem Nulldurchgang angeordnet ist als die Pumpschicht. Auf diese Art und Weise wird ein besonders geringer Füllfaktor für die Vertikalemitterschicht erzielt und in der Folge eine vorteilhaft hohe Ankopplung des Pumpstrahlungsfeldes an die Pumpschicht erreicht.

Bei einer bevorzugten Weiterbildung der Erfindung ist innerhalb des Pumpbereichs die Absorption der Pumpstrahlung in der Vertikalemitterschicht gegenüber lateral angrenzenden Bereichen der Vertikalemitterschicht erhöht. Dies bewirkt einerseits eine vorteilhafte hohe Effizienz des optischen Pumpprozesses. Andererseits wird so die laterale Propagation des Pumpstrahlungsfeldes außerhalb des Pumpbereichs nicht durch die Vertikalemitterschicht beeinträchtigt.

Eine erhöhte Absorption des Pumpstrahlungsfeldes innerhalb des Pumpbereichs wird bei der vorliegenden Erfindung in Verbindung mit dem oben genannten Wellenleiter vorzugsweise dadurch realisiert, dass die wellenführenden Eigenschaften des Wellenleiters innerhalb des Pumpbereichs gegenüber lateral angrenzenden Bereichen modifiziert sind. Diese Modifikation ist weiter bevorzugt so gestaltet, dass das Verhältnis Γₚ/Γᵥ der oben genannten Füllfaktoren der Pumpschicht rp beziehungsweise der Vertikalemitterschicht Γᵥ innerhalb des Pumpbereichs gegenüber lateral angrenzenden Bereichen erniedrigt ist. Eine entsprechende Modifikation der wellenführenden Eigenschaften ist beispielsweise dadurch möglich, dass Teile des Wellenleiters beziehungsweise Teile daran angrenzender Schichten innerhalb des Pumpbereichs teilweise abgetragen sind oder Teile des Wellenleiters beziehungsweise daran angrenzender Schichten innerhalb des Pumpbereichs zum Zwecke einer Brechungsindexänderung oxidiert oder anderweitig chemisch umgewandelt sind.

Bei einer weiteren bevorzugten Ausführungsform der Erfindung wird die oben genannte vorteilhafte Erhöhung der Absorption innerhalb des Pumpbereichs dadurch erreicht, dass innerhalb des Pumpbereichs die Pumpschicht zumindest teilweise entfernt ist. Es sei angemerkt, dass im Gegensatz zu dem oben genannten Stand der Technik diese Entfernung der Pumpschicht nach dem epitaktischen Aufwachsen der einzelnen Halbleiterschichten erfolgen kann und insbesondere keinen nachfolgenden weiteren Epitaxieprozess erfordert.

Eine vorteilhafte Weiterbildung der Erfindung besteht darin, dass außerhalb des Pumpbereichs Mittel vorgesehen sind, die die Erzeugung eines vertikal propagierenden parasitären Strahlungsfeldes unterdrückt. Damit wird vermieden, dass außerhalb des Pumpbereichs unerwünschterweise Moden anschwingen, die sich vertikal ausbreiten. Derartige Moden werden in der Regel nicht aus dem Halbleiterkörper ausgekoppelt, sondern im Halbleiterkörper oder hierauf aufgebrachten Kontaktmetallisierungen absorbiert. Sie tragen demnach nicht zur Erzeugung des vertikal emittierten Strahlungsfeldes im Pumpbereich bei und verschlechtern die Effizienz der Halbleitervorrichtung.

Zur Unterdrückung derartiger vertikal propagierender parasitärer Moden ist bei der Erfindung vorgesehen, die für den elektrischen Betrieb erforderlichen Kontaktmetallisierungen mit einer vergleichsweise geringen Reflektivität auszubilden, die insbesondere so gering gewählt ist, dass vertikale Moden nicht anschwingen können. Weitergehend können derartige vertikale Moden dadurch vermieden werden, dass eine Absorberschicht außerhalb des Pumpbereichs vorgesehen ist, mit der gezielt vertikalen Moden so hohe Verluste zugefügt werden, dass ein Anschwingen dieser Moden unterdrückt wird. Schließlich ist es auch möglich, einen für den Vertikalemitter vorgesehenen Bragg-Spiegel innerhalb des Pumpbereichs zu oxidieren, so dass dessen Reflektivität außerhalb des Pumpbereichs wesentlich geringer ist als innerhalb des Pumpbereichs. In ähnlicher Weise wie die geringe Reflektivität der Kontaktmetallisierung lässt sich damit ein Anschwingen vertikaler parasitärer Moden vermeiden.

Weitere Merkmale, Vorzüge und Zweckmäßigkeiten der Erfindung ergeben sich aus der nachfolgenden Beschreibung von sechs Ausführungsbeispielen der Erfindung in Verbindung mit den Figuren 1 bis 8.

Es zeigen:
- Figur 1: eine schematische Schnittdarstellung eines ersten Ausführungsbeispiels einer erfindungsgemäßen Halbleitervorrichtung,
- Figur 2: eine schematische Schnittdarstellung eines zweiten Ausführungsbeispiels einer erfindungsgemäßen Halbleitervorrichtung,
- Figur 3: eine schematische Schnittdarstellung eines dritten Ausführungsbeispiels einer erfindungsgemäßen Halbleitervorrichtung,
- Figur 4: eine schematische Schnittdarstellung eines vierten Ausführungsbeispiels einer erfindungsgemäßen Halbleitervorrichtung,
- Figur 5: eine schematische Schnittdarstellung eines fünften Ausführungsbeispiels einer erfindungsgemäßen Halbleitervorrichtung,
- Figur 6: eine schematische Schnittdarstellung eines sechsten Ausführungsbeispiels einer erfindungsgemäßen Halbleitervorrichtung,
- Figur 7: eine grafische Darstellung des Feldverlaufs des Pumpstrahlungsfeldes außerhalb des Pumpbereichs, und
- Figur 8: eine grafische Darstellung des Feldverlaufs des Pumpstrahlungsfeldes innerhalb des Pumpbereichs.

Gleiche oder gleichwirkende Elemente sind in den Figuren mit denselben Bezugszeichen versehen.

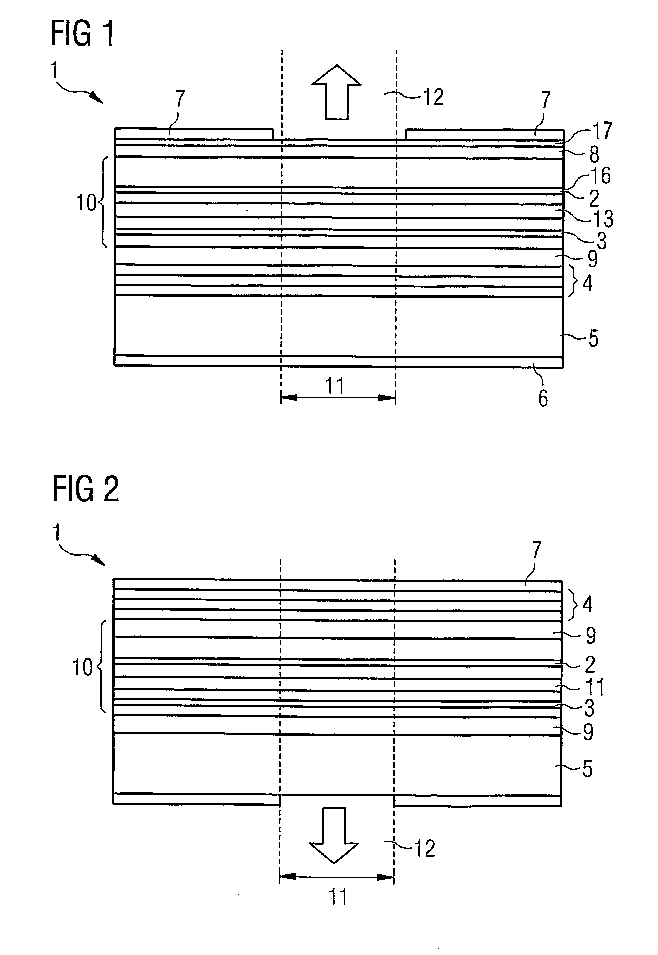

Das in Figur 1 dargestellte Ausführungsbeispiel einer erfindungsgemäßen optisch gepumpten Halbleitervorrichtung weist einen Halbleiterkörper 1 auf, der eine aktive Pumpschicht 2 sowie eine der aktiven Pumpschicht 2 in vertikaler Richtung nachgeordnete aktive Vertikalemitterschicht 3 umfasst, wobei die Pumpschicht 2 und die Vertikalemitterschicht 3 parallel zueinander angeordnet sind.

Die Pumpschicht 2 und die Vertikalemitterschicht 3 sind weiterhin innerhalb eines Wellenleiters 10 ausgebildet, an den eine erste Mantelschicht 8 und gegenüberliegend eine zweite Mantelschicht 9 grenzt.

Dem Wellenleiter in vertikaler Richtung nachgeordnet ist ein Bragg-Spiegel 4 und ein Substrat 5, das auf der den Halbleiterschichten abgewandten Seite mit einer Kontaktmetallisierung 6 versehen ist. Hierzu korrespondierend ist auf der gegenüberliegenden Seite des Halbleiterkörpers auf der ersten Mantelschicht 8 eine Kontaktschicht 17 und eine zweite Kontaktmetallisierung 7 aufgebracht, die innerhalb des Pumpbereichs 11 eine Aussparung aufweist. In diesem Bereich wird die von der Vertikalemitterschicht erzeugte und in vertikaler Richtung emittierte Strahlung 12 ausgekoppelt.

Zudem ist zwischen der Pumpschicht 2 und der Vertikalemitterschicht 3 eine ladungsträgerselektive Barriereschicht 13 angeordnet.

Das gezeigte Ausführungsbeispiel kann beispielweise auf der Basis des AlInGaAl-Materialsystems ((AlₓIn₁₋ₓ)_{y}Ga_{1-y}As, mit 0≤x≤1, 0≤y≤1) oder des AlInGaP-Materialsystems ((AlₓIn₁₋ₓ)_{y}Ga_{1-y}P, mit 0≤x≤1, 0≤y≤1) realisiert werden, im letztgenanntnen Falle etwa mit einer Pumpwellenlänge von 630 nm und einer Emissionswellenlänge des Vertikalemitters von etwa 650 nm. Als Barriereschicht 13 kann hierbei eine Stromblockierungsschicht, zum Beispiel eine Al_{0.5}In_{0.5}P-Schicht in einem (Al_{0.5}Ga_{0.5})_{0.5}In_{0.5}P-Wellenleiter, vorgesehen sein.

Für einer Figur 1 entsprechende Struktur auf AlInGaAs-Basis sind in der folgenden Tabelle beispielhaft Schichtmaterial und -dicke sowie die Dotierung angegeben. Der Bragg-Spiegel 4 umfasst bei dieser Struktur 30 Schichtpaare mit je einer Al_{1.0}Ga_{0.0}As- und einer Al_{0.2}Ga_{0.2}As-Schicht sowie auf der substratabgewandten Seite eine abschließende Al_{1.0}Ga_{0.0}As-Schicht. Im Falle eines oxidierten Bragg-Spiegels, bei dem also die Al_{1.0}Ga_{0.0}As-Schichten zu Al₂O₃-Schichten oxidiert sind, reichen etwa sechs Schichtpaare aus.

| Dicke | Material | Dotierung | | Element |
|---|---|---|---|---|
| 200m | GaAs | p | C, 1x10²⁰cm⁻³ | Kontaktschicht 17 |
| 1500 nm | Al_{0.6}Ga_{0.4}As | p | C, 1x10¹⁸cm⁻³ | Mantelschicht 8 |
| 120 nm | Al_{0.2}Ga_{0.8}As | - | - | Wellenleiter 10 |
| 10 nm | In_{0.13}Ga_{0.87}As | - | - | aktive Pumpschicht 2 |
| 120 nm | Al₀.₂Ga_{0.8}As | - | - | Wellenleiter 10 |
| 120 nm | Al_{0.6}Ga_{0.4}As | n | Te, 1x10¹⁷cm⁻³ | Barriereschicht 13 |
| 225 nm | Al₀.₂Ga_{0.8}As | n | Te, 1x10¹⁷cm⁻³ | Wellenleiter 10 |
| 10 nm | In_{0.16}Ga_{0.84}As | n | Te, 1x10¹⁷ cm⁻³ | aktive Vertikalemitter-schicht 3 |
| 375 nm | Al₀.₂Ga_{0.8}As | n | Te, 1x10¹⁷cm⁻³ | Wellenleiter 10 |
| 375 nm | Al₀.₆Ga_{0.4}As | n | Te, 1x10¹⁷cm⁻³ | Mantelschicht 9 |
| 75 nm | Al₁.₀Ga_{0.0}As | n | Te, 1x10¹⁷cm⁻³ | Bragg-Spiegel 4 |
| 75 nm (30x) | Al_{0.2}Ga_{0.8}As | n | Te, 1x10¹⁷cm⁻³ | |
| 75 nm (30x) | Al_{1.0}Ga_{0.0}As | n | Te, 1x10¹⁷cm⁻³ | |
| | GaAs | n | Te, 1x10¹⁷ cm⁻³ | Substrat 5 |

Selbstverständlich ist die Erfindung nicht auf dieses Materialsystem beschränkt, sondern kann je nach Wellenlänge und sonstigen Anforderungen auch auf der Basis anderer Halbleitermaterialsysteme wie zum Beispiel (AlₓIn₁₋ₓ)_{y}Ga_{1-y}As_{z}P_{1-z} mit 0≤x≤1, 0≤y≤1, 0≤z≤1 oder (AlₓIn₁₋ₓ) _{y}Ga₁₋yN mit 0≤x≤1, 0≤y≤1, realisiert werden.

Die Pumpstrahlungsquelle ist bei dem gezeigten Ausführungsbeispiel vorzugsweise als kantenemitterender Pumplaser ausgeführt, dessen laseraktives Medium die Pumpschicht 2 darstellt. Der Laserresonator wird von den die Pumpschicht 2 lateral begrenzenden Seitenflächen 16 gebildet, so dass die Vertikalemitterschicht 3 und insbesondere der Pumpbereich 11 des Vertikalemitters innerhalb des Pumplaserresonators angeordnet sind.

Im Betrieb werden über die Kontaktmetallisierungen 6 und 7 Ladungsträger zur Erzeugung der Pumpstrahlung in den Halbleiterkörper injiziert. Von der Auskoppelseite beziehungsweise der Kontaktmetallisierung 7 her erfolgt dabei die Injektion von Löchern als ersten Ladungsträgertyp, über die gegenüberliegende Kontaktmetallisierung 6 die Injektion von Elektronen als zweitem Ladungsträgertyp.

Aufgrund der verschiedenen Beweglichkeiten der beiden Ladungsträgertypen weisen Löcher eine höhere Nettoeinfangrate als Elektronen bei dem gezeigten Ausführungsbeispiel auf. Daher ist die Pumpschicht 2 näher an der Kontaktmetallisierung 7 angeordnet als die Vertikalemitterschicht, so dass die mittels der Kontaktmetallisierung 7 eingekoppelten Löcher bevorzugt in der Pumpschicht 2 zur strahlenden Rekombination zur Verfügung stehen und dort das Pumpstrahlungsfeld erzeugen.

Zudem dient die ladungsträgerselektive Barriereschicht 13 dazu, die Diffusion der Löcher in die darunterliegende Vertikalemitterschicht 3 zu verhindern, so dass die Wahrscheinlichkeit, dass die injizierten Ladungsträger in der Pumpschicht 2 rekombinieren, weiter erhöht wird.

Bei dem in Figur 1 dargestellten Ausführungsbeispiel ist zudem das Substrat 5, der Bragg-Spiegel 4, die Mantelschicht 9, der nachfolgende Bereich des Wellenleiters 10, die Vertikalemitterschicht 3, der nachfolgende Bereich des Wellenleiters 10 und die Barriereschicht 13 mit einem ersten Leitfähigkeitstyp dotiert. Der nachfolgende Bereich des Wellenleiters, die Pumpschicht 2 und der hierauffolgende Bereich des Wellenleiters sind undotiert, und die oberseitige erste Mantelschicht 8 ist mit dem zweiten Leitfähigkeitstyp dotiert. Beispielsweise entspricht der erste Leitfähigkeitstyp einer n-Dotierung und der zweite Leitfähigkeitstyp einer p-Dotierung.

Aufgrund dieser Dotierung bildet sich eine Raumladungszone im Bereich der Pumpschicht 2, wobei die Vertikalemitterschicht 3 außerhalb dieser Raumladungszone angeordnet ist.

Wie bereits beschrieben ist die Pumpschicht 2 bei der Erfindung so ausgeführt, dass die erzeugte Pumpstrahlung eine kleinere Wellenlänge aufweist als die innerhalb des Pumpbereichs 11 von der Vertikalemitterschicht 3 erzeugte und in vertikale Richtung emittierte Strahlung 12. Wären hierbei die Pumpschicht 2 und die Vertikalemitterschicht 3 gleichberechtigt, so würde aufgrund des Wellenlängenunterschieds bei einer gleichzeitigen elektrischen Anregung ein lateral propagierendes Strahlungsfeld zunächst von der Vertikalemitterschicht 3 angeregt werden. Dies ist aus den genannten Gründen unerwünscht und soll weitgehend vermieden werden.

Hierzu sind bei dem in Figur 1 gezeigten Ausführungsbeispiel drei Maßnahmen vorgesehen, nämlich die geringe Beabstandung der Pumpschicht von derjenigen Seite, von der die Ladungsträger mit der höheren Nettoeinfachrate injiziert werden, die Anordnung einer Barriereschicht 13 zwischen der Pumpschicht 2 und der Vertikalemitterschicht 3, und die Ausbildung einer Raumladungszone, so dass die Pumpschicht 2 innerhalb der Raumladungszone und die Vertikalemitterschicht 3 außerhalb der Raumladungszone liegt. Durch diese drei Maßnahmen wird eine Gleichberechtigung der Pumpschicht 2 und der Vertikalemitterschicht 3 hinsichtlich einer gleichzeitigen elektrischen Anregung aufgehoben, so dass in erster Linie ein lateral propagierendes Pumpstrahlungsfeld von der Pumpschicht 2 erzeugt wird.

Je nach Stärke der elektrischen Anregung wird die Erzeugung eines parasitären lateral propagierenden Strahlungsfelds durch die Vertikalemitterschicht 3 gänzlich oder zumindest in so hohem Maße, dass die Leistung des Pumpstrahlungsfeldes größer ist als die Leistung des parasitären Strahlungsfeldes, unterdrückt. Es sei angemerkt, dass im Rahmen der Erfindung bereits eine der genannten Maßnahmen zur Vermeidung eines parasitären Strahlungsfeldes ausreichen kann. Auf der anderen Seite ist es insbesondere bei starker Anregung möglich, dass noch weitere Maßnahmen erforderlich sind, um zu verhindern, dass die Vertikalemitterschicht ein lateral propagierendes Strahlungsfeld aufbaut.

Das in Figur 2 dargestellte Ausführungsbeispiel weist hinsichtlich der Pumpschicht 2, der Vertikalemitterschicht 3, der dazwischenliegenden Barriereschicht 11, des Wellenleiters 10, der angrenzenden Mantelschichten 8 und 9 sowie des Bragg-Spiegels 4 einen Figur 1 entsprechenden Aufbau auf.

Im Unterschied zu dem in Figur 1 dargestellten Ausführungsbeispiel erfolgt jedoch die Strahlungsauskopplung durch das Substrat 5 hindurch, wobei die auf dem Substrat aufgebrachte Kontaktmetallisierung 6 eine Ausnehmung innerhalb des Pumpbereichs zur Auskopplung der in vertikaler Richtung emittierter Strahlung 12 aufweist. Hingegen ist die gegenüberliegende, auf dem Bragg-Spiegel 4 angeordnete Kontaktmetallisierung 7 durchgehend und ohne Ausnehmung ausgebildet.

Bei dem in Figur 2 dargestellten Ausführungsbeispiel ist es erforderlich, dass das Substrat 5 hinsichtlich der erzeugten vertikal emittierten Strahlung 12 ausreichend strahlungsdurchlässig ist. Da elektrisch leitfähige Substrate mitunter eine eingeschränkte Transparenz aufweisen, kann es zweckmäßig sein, innerhalb des Pumpbereichs das Substrat teilweise oder auch vollständig abzutragen (nicht dargestellt).

Wie auch das in Figur 1 dargestellten Ausführungsbeispiel weist das in Figur 2 gezeigten Ausführungsbeispiel die genannten drei Maßnahmen zur Unterdrückung eines parasitären Strahlungsfeldes in der Vertikalemitterschicht auf, wobei gegebenenfalls auch eine oder zwei dieser Maßnahmen ausreichen können, oder weitere Maßnahmen zur Unterdrückung eines parasitären Strahlungsfeldes erforderlich sind. Insbesondere können bei beiden Ausführungsbeispielen die Lage der Pumpschicht 2 und der Vertikalemitterschicht 3 vertauscht sein.

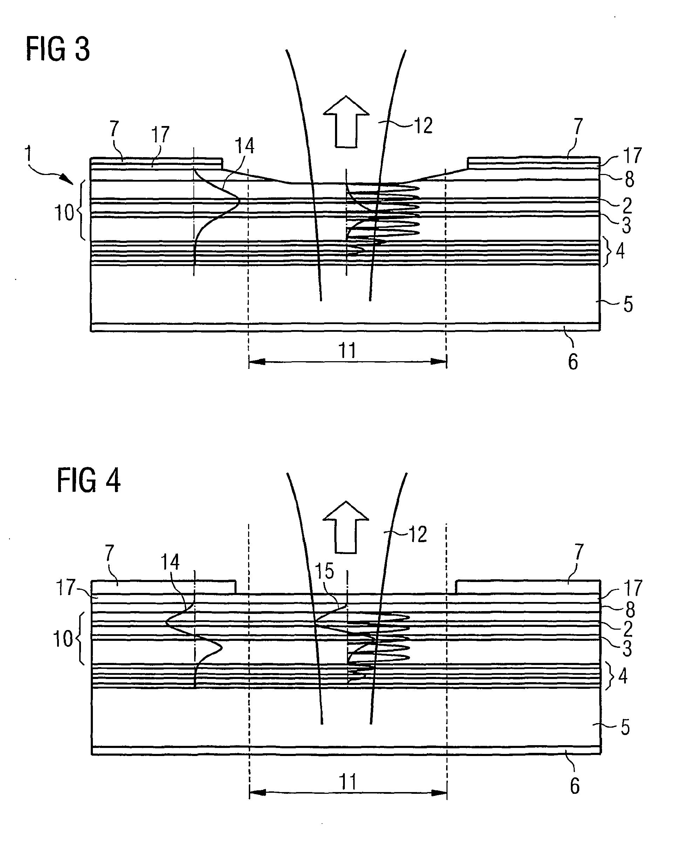

In Figur 3 ist ein drittes Ausführungsbeispiel der Erfindung dargestellt. Ähnlich wie in den bisherigen Ausführungsbeispielen weist der Halbleiterkörper 1 ein Substrat 5 auf, auf das nacheinander ein Bragg-Spiegel 4, ein Wellenleiter 10 und eine Mantelschicht 8 aufgebracht sind. Innerhalb des Wellenleiters ist die aktive Pumpschicht 2 und in vertikaler Richtung nachgeordnet und parallel zu der Pumpschicht 2 die Vertikalemitterschicht 3 ausgebildet. Das Substrat 5 ist mit einer Kontaktmetallisierung 6 und gegenüberliegend die Mantelschicht 8 mit einer Kontaktmetallisierung 7 versehen.

Durch den Wellenleiter 10 wird eine Pumpmode 14 festgelegt. Der Überlapp dieser Pumpmode mit einer der aktiven Schichten wird als Füllfaktor bezeichnet. Je größer dieser Füllfaktor ist, desto größer ist die Ankopplung der jeweiligen aktiven Schicht an das Pumpstrahlungsfeld. Im Rahmen der Erfindung ist vorgesehen, dass außerhalb des Pumpbereichs 11 die Pumpschicht einen möglichst großen Füllfaktor Γₚ aufweisen soll. Dazu ist bei dem gezeigten Ausführungsbeispiel die Pumpschicht in einem Intensitätsmaximum der Pumpmode 14 angeordnet und die Vertikalemitterschicht 3 so hiervon beabstandet, dass der Füllfaktor der Pumpschicht Γₚ größer ist als der Füllfaktor der Vertikalemitterschicht Γᵥ.

Aufgrund des größeren Füllfaktors Γₚ koppelt die Pumpschicht 2 an ein lateral im Wellenleiter propagierendes Strahlungsfeld stärker an als die Vertikalemitterschicht 3, so dass einerseits in dem Wellenleiter in erster Linie Pumpstrahlung erzeugt wird, und andererseits die Vertikalemitterschicht 3 die laterale Propagation des Pumpstrahlungsfeldes außerhalb des Pumpbereichs 11 kaum beeinträchtigt.

Es sei angemerkt, dass im Rahmen der Erfindung auch andere Möglichkeiten bestehen, eine Absorption der Pumpstrahlung außerhalb des Pumpbereichs in der Vertikalemitterschicht 3 zu reduzieren. Beispielsweise könnte die Vertikalemitterschicht außerhalb des Pumpbereichs so stark angeregt werden, dass sie ausbleicht und somit ihre Transmission erhöht wird. Aufgrund der starken Anregung steigt hierbei allerdings die Gefahr, dass sich vertikal propagierende parasitäre Moden ausbilden, so dass die vorgenannten Möglichkeiten als vorteilhafter anzusehen sind.

Innerhalb des Pumpbereichs 11 hingegen ist eine verstärkte Kopplung der Vertikalemitterschicht 3 an das Pumpstrahlungsfeld vorgesehen, da in diesem Bereich der Vertikalemitter durch das Pumpstrahlungsfeld optisch gepumpt wird. Hierzu sind die wellenführenden Eigenschaften des Wellenleiters innerhalb des Pumpbereichs 11 so modifiziert, dass der Füllfaktor der Vertikalemitterschicht Γᵥ erhöht ist beziehungsweise das Verhältnis der Füllfaktoren Γₚ/Γᵥ vermindert wird gegenüber lateral angrenzenden Bereichen außerhalb des Pumpbereichs 11.

Bei dem gezeigten Ausführungsbeispiel wird dies dadurch erreicht, dass innerhalb des Pumpbereichs 11 die Mantelschicht 8 und Teile des Wellenleiters 11 trapezförmig abgetragen sind, was zu einer Verminderung der Wellenleiterbreite führt. Die flach schräg verlaufenden Flanken der Ausnehmung bewirken einen kontinierlichen Übergang der wellenführenden Eigenschaften zum Pumpbereich hin, wodurch unerwünschte Reflexionen und Streuverluste vermieden werden.

Damit verschiebt sich das Intensitätsmaximum der Pumpmode 15 in Richtung der Vertikalemitterschicht 3, so dass deren Füllfaktor Γᵥ erhöht beziehungsweise der Füllfaktor Γₚ der Pumpschicht 2 vermindert wird. Die Verschiebung des Intensitätsmaximums ist schematisch anhand der Pumpmode 15 innerhalb des Pumpbereichs dargestellt. Weiterhin zeigt Figur 3 schematisch die Intensitätsverteilung des vertikal emittierten Strahlungsfeldes 12 innerhalb des Halbleiterkörpers. Ebenfalls dargestellt ist die laterale Ausdehnung des vertikal emittierten Strahlungsfeldes 12, etwa der 1/e-Radius des Strahlungsfeldes, der sich beugungsbedingt in Abstrahlungsrichtung vergrößert.

Figur 4 zeigt ein viertes Ausführungsbeispiel der vorliegenden Erfindung. Die Halbleitervorrichtung entspricht weitgehend dem in Figur 3 dargestellten Ausführungsbeispiel. Im Unterschied hierzu weist der Wellenleiter 10 keine Abtragung im Pumpbereich 11 auf, und der Bragg-Spiegel 4 ist innerhalb des Pumpbereichs 11 oxidiert. Vorteilhafterweise kann bei einem oxidierten Bragg-Spiegel die Anzahl der Spiegelperioden (Anzahl der Schichtpaare) gegenüber einem nicht oxidierten Bragg-Spiegel reduziert werden. So genügen beispielsweise für einen oxidierten Bragg-Spiegel etwa 5 bis 10 Spiegelperioden, während bei einem nicht oxidierten Bragg-Spiegel typischerweise 25 bis 50 Spiegelperioden vorgesehen sind. Eine geringere Zahl von Spiegelperioden reduziert sowohl den Herstellungsaufwand als auch den Wärmewiderstand des Bragg-Spiegels.

Für einen oxidierten Bragg-Spiegel eignet sich insbesondere ein Bragg-Spiegel auf der Basis des GaAs/AlGaAs-Materialsystems, vorzugsweise Schichten mit einem hohen Aluminium-Anteil. Derartige Schichten können beispielsweise feuchtthermisch, etwa in eine Wasserdampf-Atmosphäre bei einer erhöhten Temperatur von 400°C oxidiert werden. Durch die Oxidation der aluminiumhaltigen Schichten wird deren Brechungsindex maßgeblich verändert und damit in der Folge die gewünschte Modifikation der wellenführenden Eigenschaften realisiert.

Der Wellenleiter 10 ist bei diesem Ausführungsbeispiel so dimensioniert, dass die Pumpmode einen Nulldurchgang, also einen Knoten aufweist. Die Pumpschicht ist hierbei wie im vorigen Ausführungsbeispiel in einem Intensitätsmaximum der Pumpmode 14 angeordnet, die Vertikalemitterschicht hingegen im Nulldurchgang der Pumpmode 14. Dadurch wird ein maximaler Füllfaktor Γₚ der Pumpschicht 2 bei gleichzeitig minimalem Füllfaktor Γᵥ der Vertikalemitterschicht 3 realisiert.

Innerhalb des Pumpbereichs 11 wiederum sind die wellenführenden Eigenschaften des Wellenleiters 10 so modifiziert, dass das Verhältnis der Füllfaktoren Γₚ/Γᵥ abnimmt, das heißt die Ankopplung der aktiven Schichten von der Pumpschicht 2 zur Vertikalemitterschicht 3 verschoben wird. Dies wird bei dem gezeigten Ausführungsbeispiel durch die teilweise Oxidation des an den Wellenleiter 10 angrenzenden Bragg-Spiegels 4 erreicht.

Die Oxidation des Bragg-Spiegels führt zu einer Veränderung des Brechungsindexsprungs zwischen Wellenleiter 10 und Bragg-Spiegel 4, so dass außerhalb des Pumpbereichs 11 wie dargestellt die Pumpmode 14 tiefer in den Bragg-Spiegel eindringt. Innerhalb des Pumpbereichs 11 hingegen ist der Bragg-Spiegel 4 oxidiert, so dass der Brechungsindexsprung deutlich höher ist als in den lateral angrenzenden Bereichen, und sich der Nulldurchgang der Pumpmode 15 in Richtung der Pumpschicht 2 und damit weg von der Vertikalemitterschicht 3 verschiebt. Damit steigt der Füllfaktor Γᵥ der Vertikalemitterschicht und in der Folge die Ankopplung beziehungsweise die Absorption des Pumpstrahlungsfeldes in der Vertikalemitterschicht.

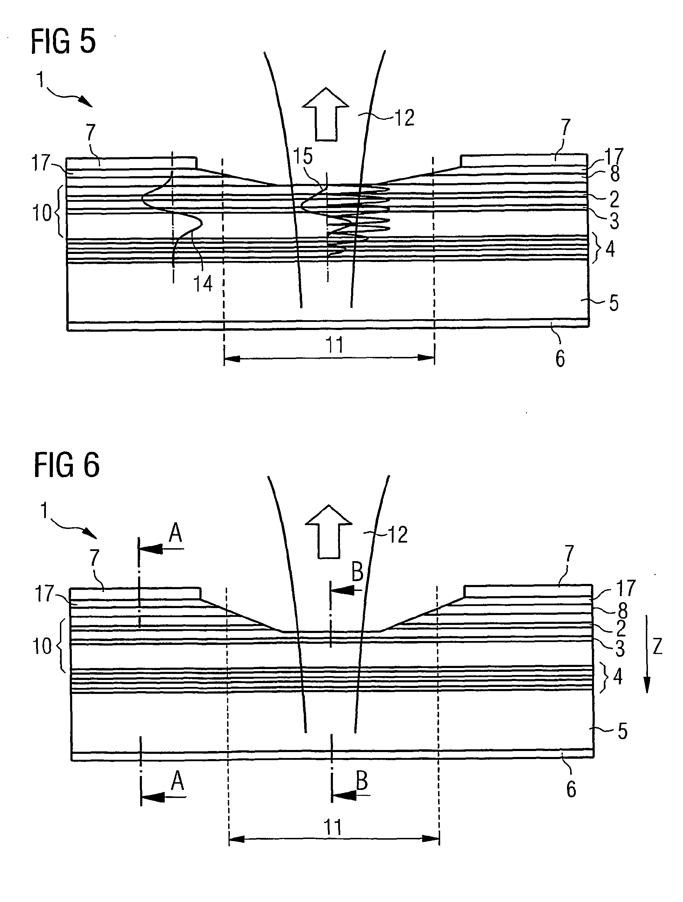

In Figur 5 ist ein fünftes Ausführungsbeispiel der Erfindung dargestellt. Dieses Ausführungsbeispiel kombiniert Merkmale der beiden in Figur 3 und Figur 4 dargestellten Ausführungsbeispiele. Der Halbleiterkörper gleicht weitgehend dem in Figur 3 dargestellten Halbleiterkörper und weist insbesondere eine Ausnehmung in der Mantelschicht 8 beziehungsweise in dem Wellenleiter 10 innerhalb des umpbereichs 11 aufweist. Hingegen ist als Pumpmode 14 wie bei dem in Figur 4 dargestellten Ausführungsbeispiel eine Mode mit einem Nulldurchgang vorgesehen, wobei wiederum die Pumpschicht 2 in einem Intensitätsmaximum der Pumpmode 14 und die Vertikalemitterschicht 3 im Nulldurchgang der Pumpmode 14 angeordnet ist. Durch die Ausnehmung der Mantelschicht 8 beziehungsweise des Wellenleiters 10 innerhalb des Pumpbereichs werden wie bei dem in Figur 3 dargestellten Ausführungsbeispiel die wellenführenden Eigenschaften des Wellenleiters so modifiziert, dass das Intensitätsmaximum von der Pumpschicht in Richtung der Vertikalemitterschicht 3 verschiebt.

In Figur 6 ist ein sechstes Ausführungsbeispiel der vorliegenden Erfindung gezeigt. Der Halbleiterkörper entspricht wiederum im wesentlichen dem in Figur 3 dargestellten Halbleiterkörper mit dem Unterschied, dass die Ausnehmung innerhalb des Pumpbereichs tiefer ausgeführt ist und sich von der Mantelschicht über den Wellenleiter 10 bis über die Pumpschicht hinaus erstreckt, also auch die Pumpschicht innerhalb des Pumpbereichs abgetragen ist. Dies ist vorteilhaft, da aufgrund der Anordnung der Kontakte 6 und 7 innerhalb des Pumpbereichs 11 im wesentlichen keine elektrische Anregung erfolgt. In diesem Bereich trägt demnach die Pumpschicht 2 nicht zur Erzeugung des Pumpstrahlungsfeldes bei, kann aber nachteiligerweise das Pumpstrahlungsfeld absorbieren. Vorzugsweise wird die Schichtenfolge innerhalb des Pumpbereichs bis zu gewünschten Tiefe abgeätzt und nachfolgend mit einer Passivierungsschicht, zum Beispiel mit einem Dielektrikum wie Siliziumnitrid, abgedeckt.

Aufgrund der Ausnehmung innerhalb des Pumpbereichs 11 werden ähnlich wie bei den in Figur 3 und in Figur 5 dargestellten Ausführungsbeispielen die wellenführenden Eigenschaften des Wellenleiters 10 modifiziert. Wie bei dem in Figur 5 dargestellten Ausführungsbeispiel ist als Pumpmode 14 eine höhere transversale Mode mit einem Nulldurchgang vorgesehen, wobei außerhalb des Pumpbereichs die Pumpschicht 2 in einem Intensitätsmaximum der Pumpmode und die Vertikalemitterschicht 3 im Nulldurchgang der Pumpmode angeordnet ist.

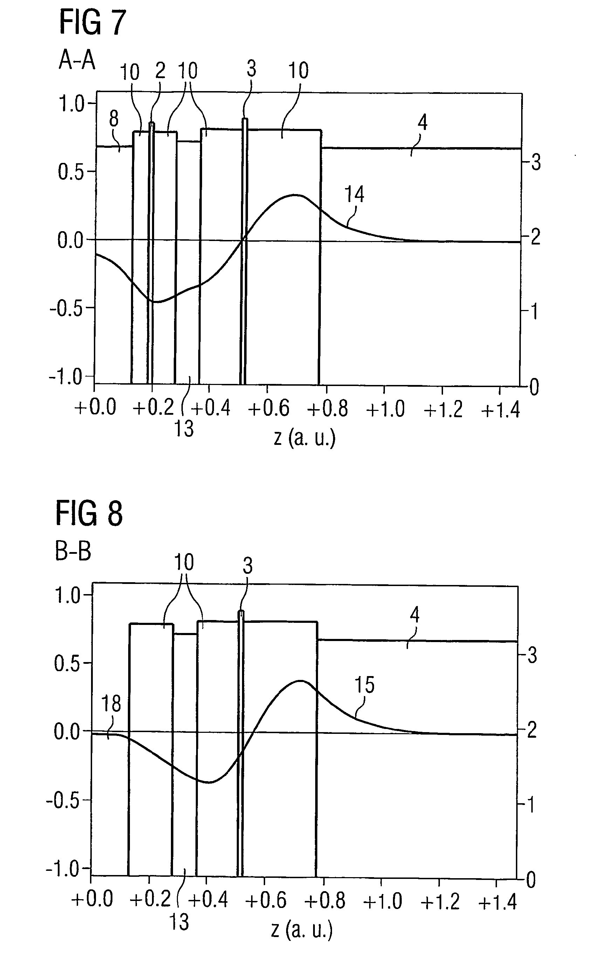

In Figur 7 ist schematisch der vertikale Intensitätsverlauf der Pumpmode entlang der Linie A-A außerhalb des Pumpbereichs dargestellt. Dieser Intensitätsverlauf wurde für eine entsprechende Halbleitervorrichtung durch Simulationsrechnungen ermittelt. Den Simulationsrechungen wurde ein AlInGaP-Schichtsystem mit einer Pumpwellenlänge von 630 nm und einer Emissionswellenlänge des Vertikalemitters von 650 nm zugrundegelegt.

Aufgetragen ist die Intensität des Pumpfeldes entlang der vertikalen Richtung z sowie der zugehörige Brechungsindex der Halbleiterschichtenfolge.

In Figur 8 ist demgegenüber ein entsprechender Verlauf der Intensität des Pumpstrahlungsfeldes innerhalb des Pumpbereichs 11 längs der Linie B-B ausschnittsweise dargestellt. Als Passivierungsschicht 18 dient eine SiN-Schicht.

Deutlich zu erkennen ist einerseits die Zusammendrängung der Pumpmode aufgrund der reduzierten Breite des Wellenleiters und andererseits eine Verschiebung der Pumpmode in Richtung der Vertikalemitterschicht. Es sei angemerkt, dass bewusst das Maximum der Pumpmode nicht bis in die Vertikalemitterschicht 3 verschoben ist, da dies zu einer zu hohen Absorption der Pumpmode innerhalb des Pumpbereichs führen kann mit der Folge, dass das Pumpstrahlungsfeld am Rande des Pumpbereichs stark abgebaut wird, und so ein inhomogenes Pumpprofil entstehen kann.

Die Erfindung ist vorzugsweise als Halbleiterscheibenlaser, beispielsweise als VCSEL oder VECSEL ausgeführt. Insbesondere ist der Vertikalemitter zur Bildung eines vertikal emittierenden Lasers mit einem externen Resonator (VECSEL) vorgesehen, wobei der Resonator von dem Bragg-Spiegel und einen externen Spiegel gebildet wird.

Bei einer bevorzugten Weiterbildung dieser Ausführungsform ist innerhalb des externen Resonators ein Element zur Frequenzkonversion, beispielsweise zur Frequenzverdopplung vorgesehen. Hierfür eignen sich beispielsweise nichtlineare optische Elemente, insbesondere nichtlineare Kristalle.

Die Erläuterung der Erfindung anhand der Ausführungsbeispiele ist selbstverständlich nicht als Beschränkung der Erfindung hierauf zu verstehen. Vielmehr umfasst die Erfindung auch die Kombination sämtlicher in den Ausführungsbeispiele und der sonstigen Beschreibung genannten Merkmale, auch wenn diese Kombination nicht Gegenstand eines Patentanspruchs ist.

## Patentansprüche

1. Halbleitervorrichtung mit
einem optisch gepumpten Vertikalemitter, der eine aktive Vertikalemitterschicht (3) aufweist,
und einer Pumpstrahlungsquelle, mittels der ein in lateraler Richtung propagierendes Pumpstrahlungsfeld erzeugt wird, das die Vertikalemitterschicht (3) in einem Pumpbereich optisch pumpt, wobei die Wellenlänge des Pumpstrahlungsfeldes kleiner ist als die Wellenlänge des von dem Vertikalemitter generierten Strahlungsfeldes (12),
**dadurch gekennzeichnet, dass**
die Pumpstrahlungsquelle eine aktive Pumpschicht (2) aufweist, die der Vertikalemitterschicht (3) in vertikaler Richtung nachgeordnet ist und die in vertikaler Richtung gesehen zumindest teilweise mit der Vertikalemitterschicht (3) überlappt, wobei die aktive Pumpschicht so angeordnet ist, dass das im Betrieb erzeugte Pumpstrahlungsfeld (14, 15) eine höhere Leistung aufweist als ein parasitäres von der Vertikalemitterschicht (3) erzeugtes, lateral propagierendes Strahlungsfeld, oder dass die Erzeugung eines parasitären, lateral propagierenden Strahlungsfeldes durch die Vertikalemitterschicht (3) unterdrückt wird.

2. Halbleitervorrichtung nach Anspruch 1,
**dadurch gekennzeichnet, dass**
die Pumpstrahlungsquelle elektrisch durch Ladungsträgerinjektion zur Erzeugung der Pumpstrahlung angeregt wird.

3. Halbleitervorrichtung nach Anspruch 2,
**dadurch gekennzeichnet, dass**
in die Halbleitervorrichtung Ladungsträger eines ersten Ladungsträgertyps und Ladungsträger eines zweiten Ladungsträgertyps injiziert werden.

4. Halbleitervorrichtung nach Anspruch 3,
**dadurch gekennzeichnet, dass**
die Ladungsträger des ersten Ladungsträgertyps eine höhere Nettoeinfangrate als die Ladungsträger des zweiten Ladungsträgertyps aufweisen und von einer Seite in die Halbleitervorrichtung injiziert werden, wobei die Pumpschicht (2) einen geringeren Abstand zu dieser Seite aufweist als die Vertikalemitterschicht (3).

5. Halbleitervorrichtung nach Anspruch 3 oder 4,
**dadurch gekennzeichnet, dass**
zwischen der Vertikalemitterschicht (3) und der Pumpschicht (2) eine Barriere gebildet ist, die eine Selektivität hinsichtlich des Ladungsträgertyps aufweist.

6. Halbleitervorrichtung nach einem der Ansprüche 3 bis 5,
**dadurch gekennzeichnet, dass**
die Halbleitervorrichtung teilweise mit einem ersten Leitfähigkeitstyp und teilweise mit dem zweiten Leitfähigkeitstyp dotiert ist und eine Raumladungszone aufweist, wobei die Pumpschicht (2) innerhalb der Raumladungszone und die Vertikalemitterschicht (3) außerhalb der Raumladungszone angeordnet ist.

7. Halbleitervorrichtung nach einem der Ansprüche 1 bis 6,
**dadurch gekennzeichnet, dass**
die Pumpschicht (2) und die Vertikalemitterschicht (3) innerhalb eines Wellenleiters (10) angeordnet sind.

8. Halbleitervorrichtung nach Anspruch 7,
**dadurch gekennzeichnet, dass**
dem Wellenleiter (10) außerhalb des Pumpbereichs (1) eine Pumpmode (14, 15) mit einem Füllfaktor Γₚ der Pumpschicht und
einem Füllfaktor Γᵥ der Vertikalemitterschicht zugeordnet ist, wobei der Füllfaktor der Pumpschicht Γₚ größer als der Füllfaktor der Vertikalemitterschicht Γᵥ ist.

9. Halbleitervorrichtung nach Anspruch 7 oder 8,
**dadurch gekennzeichnet, dass**
der Pumpmode (14) ein Intensitätsmaximum zugeordnet ist, und
die Pumpschicht (2) näher an dem Intensitätsmaximum angeordnet ist als die Vertikalemitterschicht (3).

10. Halbleitervorrichtung nach einem der Ansprüche 7 bis 9,
**dadurch gekennzeichnet, dass**
die Pumpmode (14) einen Nulldurchgang aufweist, und die Vertikalemitterschicht (3) näher an dem Nulldurchgang angeordnet ist als die Pumpschicht (2).

11. Halbleitervorrichtung nach einem der Ansprüche 1 bis 10,
**dadurch gekennzeichnet, dass**
innerhalb des Pumpbereichs (11) die Absorption der Pumpstrahlung in der Vertikalemitterschicht (3) gegenüber lateral an den Pumpbereich (11) angrenzenden Bereichen der Vertikalemitterschicht (3) erhöht ist.

12. Halbleitervorrichtung nach Anspruch 11,
**dadurch gekennzeichnet, dass**
das Pumpstrahlungsfeld bezüglich der Pumpschicht (2) einen Füllfaktor Γₚ und bezüglich der Vertikalemitterschicht (3) einen Füllfaktor Γᵥ aufweist, wobei das Verhältnis Γₚ/Γᵥ innerhalb des Pumpbereichs (11) gegenüber lateral an den Pumpbereich (11) angrenzenden Bereichen der Vertikalemitterschicht (3) erniedrigt ist.

13. Halbleitervorrichtung nach Anspruch 11 oder 12,
**dadurch gekennzeichnet, dass**
die Pumpschicht (2) und die Vertikalemitterschicht (3) innerhalb eines Wellenleiters (10) angeordnet sind, dessen wellenführende Eigenschaften innerhalb des Pumpbereichs (11) gegenüber lateral an den Pumpbereich (11) angrenzenden Bereichen modifiziert sind.

14. Halbleitervorrichtung nach Anspruch 13,
**dadurch gekennzeichnet, dass**
innerhalb des Pumpbereichs (11) der Wellenleiter (10) oder daran angrenzende Schichten zumindest teilweise entfernt sind.

15. Halbleitervorrichtung nach einem der Ansprüche 11 bis 14,
**dadurch gekennzeichnet, dass**
innerhalb des Pumpbereichs (11) der Wellenleiter (10) oder daran angrenzende Schichten zumindest teilweise oxidiert sind.

16. Halbleitervorrichtung nach einem der Ansprüche 1 bis 15,
**dadurch gekennzeichnet, dass**
die Pumpschicht (2) innerhalb des Pumpbereichs (11) zumindest teilweise entfernt ist.

17. Halbleitervorrichtung nach einem der Ansprüche 1 bis 16,
**dadurch gekennzeichnet, dass**
außerhalb des Pumpbereichs (11) Mittel zur Unterdrückung vertikal propagierender, parasitärer Strahlungsfelder vorgesehen sind.

18. Halbleitervorrichtung nach Anspruch 17
**dadurch gekennzeichnet, dass**
für Kontaktmetallisierungen (6,7) ein Material gewählt ist, dessen Reflektivität so gering ist, dass das Anschwingen vertikal propagierende Moden von parasitären Strahlungsfeldern unterdrückt wird.

19. Halbleitervorrichtung nach Anspruch 17 oder 18
**dadurch gekennzeichnet, dass**
außerhalb des Pumpbereichs (11) eine Absorberschicht zur Unterdrückung vertikal propagierender, parasitärer Strahlungsfelder vorgesehen ist.

20. Halbleitervorrichtung nach einem der Ansprüche 1 bis 19,
**dadurch gekennzeichnet, dass**
der Pumpschicht (2) und der Vertikalemitterschicht (3) in vertikaler Richtung eine Spiegelschicht (4) nachgeordnet ist.

21. Halbleitervorrichtung nach Anspruch 20,
**dadurch gekennzeichnet, dass**
die Spiegelschicht (4) innerhalb des Pumpbereichs (11) oxidiert ist.

22. Halbleitervorrichtung nach Anspruch 20 oder 21,
**dadurch gekennzeichnet, dass**
die Spiegelschicht (4) zwischen der Vertikalemitterschicht (3) und einem Substrat (5) angeordnet ist, und die von der Vertikalemitterschicht generierte Strahlung (12) auf der dem Substrat gegenüberliegenden Seite ausgekoppelt wird.

23. Halbleitervorrichtung nach Anspruch 20 oder 21,
**dadurch gekennzeichnet, dass**
die Vertikalemitterschicht (3) zwischen der Spiegelschicht (4) und einem Substrat (5) angeordnet ist, und die von der Vertikalemitterschicht generierte Strahlung (12) durch das Substrat (5) ausgekoppelt wird.

24. Halbleitervorrichtung nach einem der Ansprüche 1 bis 23,
**dadurch gekennzeichnet, dass**
dem Vertikalemitter ein externer Resonator zugeordnet ist.

25. Halbleitervorrichtung nach Anspruch 24 und einem der Ansprüche 20 bis 23,
**dadurch gekennzeichnet, dass**
der externe Resonator von der Spiegelschicht (4) und einem externen Spiegel gebildet wird.

26. Halbleitervorrichtung nach Anspruch 24 oder 25,
**dadurch gekennzeichnet, dass**
innerhalb des externen Resonators ein Element zur Frequenzkonversion, insbesondere zur Frequenzverdopplung angeordnet ist.

27. Halbleitervorrichtung nach einem der Ansprüche 1 bis 26,
**dadurch gekennzeichnet, dass**
die Halbleitervorrichtung monolithisch integriert ausgebildet ist.

## Claims

1. Semiconductor device comprising an optically pumped vertical emitter having an active vertical emitter layer (3),
and a pump radiation source, which is used to generate a pump radiation field which propagates in the lateral direction and optically pumps the vertical emitter layer (3) in a pump region, the wavelength of the pump radiation field being less than the wavelength of the radiation field (12) generated by the vertical emitter,
**characterized in that**
the pump radiation source has an active pump layer (2), which is arranged downstream of the vertical emitter layer (3) in the vertical direction and which at least partly overlaps the vertical emitter layer (3) as seen in the vertical direction, the active pump layer being arranged in such a way that the pump radiation field (14, 15) generated during operation has a higher power than a parasitic laterally propagating radiation field generated by the vertical emitter layer (3) or that the generation of a parasitic laterally propagating radiation field by the vertical emitter layer (3) is suppressed.

2. Semiconductor device according to claim 1,
**characterized in that**
the pump radiation source is electrically excited by charge carrier injection for generation of the pump radiation.

3. Semiconductor device according to claim 2,
**characterized in that**
charge carriers of a first charge carrier type and charge carriers of a second charge carrier type are injected into the semiconductor device.

4. Semiconductor device according to claim 3,
**characterized in that**
the charge carriers of the first charge carrier type have a higher net trapping rate than the charge carriers of the second charge carrier type and are injected into the semiconductor device from a side, the pump layer (2) being at a smaller distance from said side than the vertical emitter layer (3).

5. Semiconductor device according to claim 3 or 4,
**characterized in that**
a barrier having a selectivity with regard to the charge carrier type is formed between the vertical emitter layer (3) and the pump layer (2).

6. Semiconductor device according to one of claims 3 to 5,
**characterized in that**
the semiconductor device is doped partly with a first conductivity type and partly with the second conductivity type and has a space charge zone, the pump layer (2) being arranged within the space charge zone and the vertical emitter layer (3) being arranged outside the space charge zone.

7. Semiconductor device according to one of claims 1 to 6,
**characterized in that**
the pump layer (2) and the vertical emitter layer (3) are arranged within a waveguide (10).

8. Semiconductor device according to claim 7,
**characterized in that**
a pump mode (14, 15) having a filling factor Γₚ of the pump layer and a filling factor Γᵥ of the vertical emitter layer is assigned to the waveguide (10) outside the pump region (1), the filling factor of the pump layer Γₚ being greater than the filling factor of the vertical emitter layer Γᵥ.

9. Semiconductor device according to claim 7 or 8,
**characterized in that**
an intensity maximum is assigned to the pump mode (14), and the pump layer (2) is arranged closer to the intensity maximum than the vertical emitter layer (3).

10. Semiconductor device according to one of claims 7 to 9,
**characterized in that**
the pump mode (14) has a zero crossing, and the vertical emitter layer (3) is arranged closer to the zero crossing than the pump layer (2).

11. Semiconductor device according to one of claims 1 to 10,
**characterized in that**
within the pump region (11), the absorption of the pump radiation in the vertical emitter layer (3) is increased compared with regions of the vertical emitter layer (3) which laterally adjoin the pump region (11).

12. Semiconductor device according to claim 11,
**characterized in that**
the pump radiation field has a filling factor Γₚ with regard to the pump layer (2) and a filling factor Γᵥ with regard to the vertical emitter layer (3), the ratio Γₚ/Γᵥ being decreased within the pump region (11) compared with regions of the vertical emitter layer (3) which laterally adjoin the pump region (11).

13. Semiconductor device according to claim 11 or 12,
**characterized in that**
the pump layer (2) and the vertical emitter layer (3) are arranged within a waveguide (10) whose wave-guiding properties are modified within the pump region (11) compared with regions which laterally adjoin the pump region (11).

14. Semiconductor device according to claim 13,
**characterized in that**
the waveguide (10) or layers adjoining the latter are at least partly removed within the pump region (11).

15. Semiconductor device according to one of claims 11 to 14,
**characterized in that**
the waveguide (10) or layers adjoining the latter are at least partly oxidized within the pump region (11).

16. Semiconductor device according to one of claims 1 to 15,
**characterized in that**
the pump layer (2) is at least partly removed within the pump region (11).

17. Semiconductor device according to one of claims 1 to 16,
**characterized in that**
means for suppressing vertically propagating parasitic radiation fields are provided outside the pump region (11).

18. Semiconductor device according to claim 17,
**characterized in that**
a material whose reflectivity is low enough to suppress the oscillation build-up of vertically propagating modes of parasitic radiation fields is chosen for contact metalizations (6, 7).

19. Semiconductor device according to claim 17 or 18,
**characterized in that**
an absorber layer for suppressing vertically propagating parasitic radiation fields is provided outside the pump region (11).

20. Semiconductor device according to one of claims 1 to 19,
**characterized in that**
a mirror layer (4) is arranged downstream of the pump layer (2) and the vertical emitter layer (3) in the vertical direction.

21. Semiconductor device according to claim 20,
**characterized in that**
the mirror layer (4) is oxidized within the pump region (11).

22. Semiconductor device according to claim 20 or 21,
**characterized in that**
the mirror layer (4) is arranged between the vertical emitter layer (3) and a substrate (5), and the radiation (12) generated by the vertical emitter layer is coupled out on the opposite side to the substrate.

23. Semiconductor device according to claim 20 or 21,
**characterized in that**
the vertical emitter layer (3) is arranged between the mirror layer (4) and a substrate (5), and the radiation (12) generated by the vertical emitter layer is coupled out through the substrate (5).

24. Semiconductor device according to one of claims 1 to 23,
**characterized in that**
an external resonator is assigned to the vertical emitter.

25. Semiconductor device according to claim 24 and one of claims 20 to 23,
**characterized in that**
the external resonator is formed by the mirror layer (4) and an external mirror.

26. Semiconductor device according to claim 24 or 25,
**characterized in that**
an element for frequency conversion, in particular for frequency doubling, is arranged within the external resonator.

27. Semiconductor device according to one of claims 1 to 26,
**characterized in that**
the semiconductor device is formed in monolithically integrated fashion.

## Revendications

1. Dispositif semiconducteur qui présente un émetteur vertical pompé optiquement et doté d'une couche active (3) d'émetteur vertical et
une source de rayonnement de pompage qui permet de former un champ de rayonnement de pompage qui se propage dans la direction latérale et qui pompe optiquement la couche (3) d'émetteur vertical dans une zone de pompage,
la longueur d'onde du champ de rayonnement de pompage étant inférieure à la longueur d'onde du champ de rayonnement (12) produit par l'émetteur vertical,
**caractérisé en ce que**
la source de rayonnement de pompage présentant une couche active de pompage (2) disposée en aval de la couche d'émetteur vertical (3) dans la direction verticale et qui recouvre au moins en partie la couche d'émetteur vertical (3) dans la direction verticale,
**en ce que** la couche active de pompage est disposée de telle sorte que le champ de rayonnement de pompage (14, 15) produit en fonctionnement présente une puissance plus élevée qu'un champ de rayonnement parasite produit par la couche d'émetteur vertical (3) et se propageant verticalement ou que la formation d'un champ de rayonnement parasite se propageant latéralement par la couche d'émetteur vertical (3) soit empêchée.

2. Dispositif semiconducteur selon la revendication 1, **caractérisé en ce que** la source de rayonnement de pompage est excitée électriquement par injection de porteurs de charge en vue de former le rayonnement de pompage.

3. Dispositif semiconducteur selon la revendication 2, **caractérisé en ce que** des porteurs de charge d'un premier type de porteur de charge et des porteurs de charge d'un deuxième type de porteurs de charge sont injectés dans le dispositif semiconducteur.

4. Dispositif semiconducteur selon la revendication 3, **caractérisé en ce que** les porteurs de charge du premier type de porteurs de charge ont un taux net de piégeage supérieur à celui des porteurs de charge du deuxième type de porteurs de charge et sont injectés par un côté dans le dispositif semiconducteur, la couche de pompage (2) présentant par rapport à ce côté un écart plus petit que la couche d'émetteur vertical (3).

5. Dispositif semiconducteur selon les
revendications 3 ou 4, **caractérisé en ce qu'**une barrière qui présente une sélectivité vis-à-vis des types de porteurs de charge est formée entre la couche d'émetteur vertical (3) et la couche de pompage (2).

6. Dispositif semiconducteur selon l'une des revendications 3 à 5, **caractérisé en ce que** le dispositif semiconducteur est dopé en partie par un premier type de porteurs de charge et en partie par un deuxième type de porteurs de charge et présente une zone spatiale de chargement, la couche de pompage (2) étant disposée à l'intérieur de la zone spatiale de chargement et la couche d'émetteur vertical (3) à l'extérieur de la zone spatiale de chargement.

7. Dispositif semiconducteur selon l'une des revendications 1 à 6, **caractérisé en ce que** la couche de pompage (2) et la couche d'émetteur vertical (3) sont disposées à l'intérieure d'un guide d'ondes (10).

8. Dispositif semiconducteur selon la revendication 7, **caractérisé en ce qu'**un mode de pompage (14, 15) qui présente un facteur de remplissage Γₚ de la couche de pompage et un facteur de remplissage Γᵥ de la couche d'émetteur vertical est associé au conducteur d'ondes (10) à l'extérieur de la zone de pompage (1), le facteur de remplissage Γₚ de la couche de pompage étant supérieur au facteur de remplissage Γᵥ de la couche d'émetteur vertical.

9. Dispositif semiconducteur selon les revendications 7 ou 8, **caractérisé en ce qu'**un maximum d'intensité est associé au mode de pompage (14) et **en ce que** la couche de pompage (2) est située plus près du maximum d'intensité que la couche d'émetteur vertical (3).

10. Dispositif semiconducteur selon l'une des revendications 7 à 9, **caractérisé en ce que** le mode de pompage (14) présente un passage par zéro et **en ce que** la couche d'émetteur vertical (3) est disposée plus près du passage par zéro que la couche de pompage (2).

11. Dispositif semiconducteur selon l'une des revendications 1 à 10, **caractérisé en ce que** l'absorption du rayonnement de pompage dans la couche d'émetteur vertical (3) est plus élevée à l'intérieur de la zone de pompage (11), que dans les parties de la couche d'émetteur vertical (3) adjacentes latéralement à la zone de pompage (11).

12. Dispositif semiconducteur selon la revendication 11, **caractérisé en ce que** le champ de rayonnement de pompage présente un facteur de remplissage Γₚ par rapport à la couche de pompage (2) et un facteur de remplissage Γᵥ par rapport à la couche d'émetteur vertical (3), le rapport Γₚ/Γᵥ étant abaissé à l'intérieur de la zone de pompage (11) par rapport aux parties de la couche d'émetteur vertical (3) adjacentes latéralement à la zone de pompage (11).

13. Dispositif semiconducteur selon les revendications 11 ou 12, **caractérisé en ce que** la couche de pompage (2) et la couche d'émetteur vertical (3) sont disposées à l'intérieur d'un guide d'ondes (10) dont les propriétés de guidage d'ondes à l'intérieur de la zone de pompage (11) sont modifiées par rapport aux parties adjacentes latéralement à la zone de pompage (11).

14. Dispositif semiconducteur selon la revendication 13, **caractérisé en ce que** le guide d'ondes (10) ou des couches qui lui sont adjacentes sont enlevées au moins en partie à l'intérieur de la zone de pompage (11).

15. Dispositif semiconducteur selon l'une des revendications 11 à 14, **caractérisé en ce que** le guide d'ondes (10) ou des couches qui lui sont adjacentes sont oxydés au moins partiellement à l'intérieur de la zone de pompage (11).

16. Dispositif semiconducteur selon l'une des revendications 1 à 15, **caractérisé en ce qu'**au moins une partie de la couche de pompage (2) est enlevée à l'intérieur de la zone de pompage (11).

17. Dispositif semiconducteur selon l'une des revendications 1 à 16, **caractérisé en ce que** des moyens qui diminuent les champs de rayonnement parasites se propageant verticalement sont prévus à l'extérieur de la zone de pompage (11).

18. Dispositif semiconducteur selon la revendication 17, **caractérisé en ce que** pour les métallisations de contact (6, 7), on sélectionne un matériau dont la réflectivité est suffisamment basse pour empêcher l'excitation de modes à propagation verticale de champs de rayonnement parasites.

19. Dispositif semiconducteur selon les revendications 17 ou 18, **caractérisé en ce qu'**une couche d'absorption qui diminue les champs de rayonnement parasites se propageant verticalement est prévue à l'extérieur de la zone de pompage (11).

20. Dispositif semiconducteur selon l'une des revendications 1 à 19, **caractérisé en ce qu'**une couche réfléchissante (4) est prévue en aval de la couche de pompage (2) et de la couche d'émetteur vertical (3) dans la direction verticale.

21. Dispositif semiconducteur selon la revendication 20, **caractérisé en ce que** la couche réfléchissante (4) est oxydée à l'intérieur de la zone de pompage (11).

22. Dispositif semiconducteur selon les revendications 20 ou 21, **caractérisé en ce que** la couche réfléchissante (4) est disposée entre la couche d'émetteur vertical (3) et un substrat (5) et **en ce que** le rayonnement (12) produit par la couche d'émetteur vertical est émis sur le côté opposé au substrat.

23. Dispositif semiconducteur selon les revendications 20 ou 21, **caractérisé en ce que** la couche d'émetteur vertical (3) est disposée entre la couche réfléchissante (4) et un substrat (5) et **en ce que** le rayonnement (12) produit par la couche d'émetteur vertical est émis à travers le substrat (5).

24. Dispositif semiconducteur selon l'une des revendications 1 à 23, **caractérisé en ce qu'**un résonateur externe est associé à l'émetteur vertical.

25. Dispositif semiconducteur selon la revendication 24 et l'une des revendications 20 à 23, **caractérisé en ce que** le résonateur externe est formé par la couche réfléchissante (4) et un miroir externe.

26. Dispositif semiconducteur selon les revendications 24 ou 25, **caractérisé en ce qu'**un élément de conversion de fréquence et en particulier de doublement de fréquence est disposé à l'intérieur du résonateur externe.

27. Dispositif semiconducteur selon l'une des revendications 1 à 26, **caractérisé en ce que** le dispositif semiconducteur forme un monolithe intégré.
